# EUROPÄISCHE PATENTSCHRIFT

(11) **EP 0 391 024 B1**
(45) Veröffentlichungstag und Bekanntmachung des Hinweises auf die Patenterteilung: **01.03.1995**
(21) Anmeldenummer: 90100970.4
(22) Anmeldetag: 18.01.1990
(51) Int. Cl.: G02F 1/13

(54) **Schaltungsanordnung für Anzeigevorrichtung**
Circuit for display device
Circuit pour dispositif d'affichage

(30) Priorität: 05.04.1989 DE 3910963
(43) Veröffentlichungstag der Anmeldung: 10.10.1990
(73) Patentinhaber: Licentia Patent-Verwaltungs-GmbH, 60596 Frankfurt (DE)
(72) Erfinder: Wiemer, Wolfram, Dr. rer. nat., D-7906 Blaustein (DE)
(74) Vertreter: Amersbach, Werner, Dipl.-Ing.

(56) Entgegenhaltungen:
- DE-A- 3 426 715
- GB-A- 2 151 834
- GB-A- 2 160 693
- GB-A- 2 166 899
- FEINWERKTECHNIK & MESSTECHNIK, Band 94, Nr. 4, Mai 1986, Seiten 251-252, Carl Hanser Verlag, München, DE; E. WEISE et al.:"Elektrische und mechanische Verbindung von Flüssigkristall-Anzeigen (LCD) und Treiberbausteinen"
- TE - TOUTE L'ELECTRONIQUE, Nr. 534, Mai 1988, Seiten 18-23, Paris, FR; "TV couleur : Technique des écrans à cristaux liquides"
- PATENT ABSTRACTS OF JAPAN, Band 13, Nr. 47 (P-822)[3395], 3. Februar 1989, Seite 119 P 822 ; & JP-A-63 241 523

## Beschreibung

Die Erfindung betrifft eine Schaltungsanordnung nach dem Oberbegriff des Patentanspruchs 1.

Eine derartige Schaltungsanordnung ist aus der Zeitschrift "Feinwerktechnik & Meßtechnik", Band 94, Nr. 4, Mai 1986, Seiten 251 und 252 bekannt.

Aus der DE-A-34 26 715 ist es bekannt, die Anschlüsse eines Treiberbausteins mit Leiterbahnen auf einem überstehenden Glassubstrat einer elektrooptischen Zelle zu verbinden und den Treiberbaustein auf diesem überstehenden Glassubstrat anzuordnen.

Schaltungsanordnungen der vorstehenden Art dienen bevorzugt der Ansteuerung von Flüssigkristall-Anzeigezellen wobei das die Schaltungsanordnung aufweisende Glassubstrat eine der beiden Deckplatten der Flüssigkristallzelle ist. Die Technik, Ansteuer-IC's direkt auf den Glasplatten von Flüssigkristallzellen anzubringen ist als COG (Chip-on-glass)-Technik bekannt. Es ist dabei bekannt, die Leiterbahnen auf den Glassubstraten als ITO-Bahnen (Indium-Tin-Oxyd-Bahnen) oder als Metallisierungsschichten direkt auf der Glasoberfläche anzubringen.

Während ITO-Bahnen als Elektroden und Elektrodenzuführungen für Flüssigkristallzellen gut geeignet sind, macht sich die geringere Leitfähigkeit dieser ITO-Schichten dann störend bemerkbar, wenn sie zur Versorgung mehrerer IC dienen. Deshalb hat man auch schon die Versorgungsleitungen als Metallisierungsbahnen auf der Glasoberfläche ausgebildet. Diese Technik bedarf jedoch einer Vielzahl zusätzlicher Fertigungsschritte, die nicht zuletzt wegen chemischer Nebenwirkungen Ausfallrisiken mit sich bringen.

Der vorliegenden Erfindung liegt die Aufgabe zugrunde eine insbesondere für Flüssigkristallanzeigevorrichtungen geeignete Schaltungsanordnung der eingangs genannten Art so zu verbessern, daß bei einfacher Herstellung Leiterbahnen unterschiedlicher Art vorhanden sind.

Diese Aufgabe wird durch die im kennzeichnenden Teil des Anspruchs 1 genannten Merkmale gelöst.

Ein wesentlicher Vorteil der Erfindung wird darin gesehen, daß die Herstellung solcher Schaltungsanordnungen mit unterschiedlichen Leiterbahnen sehr einfach ist. Als vorteilhaft wird weiter angesehen, daß insbesondere das Aufbringen der Versorgungsleitungen keine störend hohe Temperaturen benötigt und keine chemische Beeinträchtigungen bereits vorhandener Bahnen und Anordnungen auftreten.

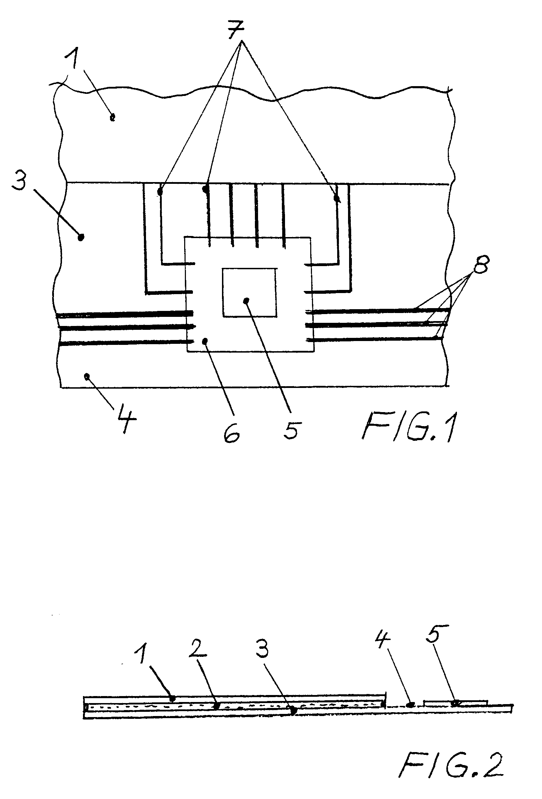

Anhand des in den FIG. 1 und 2 schematisch dargestellten bevorzugten Ausführungsbeispiels wird die Erfindung nachfolgend näher erläutert.

Die FIG. 2 zeigt eine Seitenansicht einer mit einer erfindungsgemäßen Schaltungsanordnung versehenen Flüssigkristall-Anzeigevorrichtung mit zwei gläsernen Deckplatten 1 und 3 zwischen welchen sich in bekannter Weise die Flüssigkristallschicht 2 befindet. Die eine Deckplatte 3 ist größer als die andere Deckplatte 1 und auf ihrer die Deckplatte 1 überragenden Oberfläche 4 befindet sich ein IC 5 und die dazu gehörige Schaltung wie in FIG. 1, die eine Aufsicht auf einen Ausschnitt der Flüssigkristallanzeigevorrichtung zeigt, detaillierter dargestellt ist.

Auf der Oberfläche 4 des die Deckplatte 1 überragenden Teils der Deckplatte 3, die aus Glas besteht, befinden sich die als Zuführungen zu dem Treiber IC 5 ausgebildeten Leiterbahnen 7 und 8.

Die Leiterbahnen 7 dienen der Zuführung der Ansteuersignale von IC 5 zu den in der Flüssigkristallzelle in üblicher Weise angeordneten Elektroden, mit deren Hilfe die Flüssigkristallschicht in gewünschten Teilbereichen bezüglich ihrer Lichtdurchlässigkeit verändert werden kann.

Diese Leiterbahnen 7, die in das Innere der Flüssigzelle hineinreichen, bestehen aus einer ITO-(Inidium-Tin-Oxid)-Schicht, die in bekannter Weise auf der Glasoberfläche 4 abgeschieden wird. Solche Schichten sind sehr dünn und eignen sich nur zur Leitung verhältnismäßig geringer Ströme. Die Elektroden im Innern der Flüssigkristallzelle bestehen üblicherweise ebenfalls aus solchen ITO-Schichten.

Die Versorgungsspannung und Signale für den IC 5 werden über Versorgungsleitungen 8 auf der Glasoberfläche 4 zugeführt. Insbesondere bei Vorhandensein mehrerer IC können bei diesen Leitungen vergleichsweise höhere Ströme fließen. Die Erfindung sieht nun vor, daß diese Versorgungsleiterbahnen 8 im Gegensatz zu den Ansteuerleiterbahnen 7 aus Metallfilmen bestehen, die direkt oder indirekt auf die Glasoberfläche 4 aufgeklebt sind.

Im Falle des Direktaufklebens bestehen diese Leiterbahnen 8 aus Metallfolien. Gemäß einer bevorzugten Ausführungsart bestehen diese Leiterbahnen 8 aus Metallschichten, die auf ein Kunststoffband aufgebracht sind. Die indirekte Verklebung mit der Glasoberfläche 4 erfolgt in der Weise, daß das die Metallschichtbahnen tragende Kunststoffband auf die Glasoberfläche aufgeklebt wird.

Die elektrische Kontaktierung zwischen den Anschlüssen des IC 5 und den Leiterbahnen 7 und 8 erfolgt mittels eines elektrisch leitfähigen Klebers. Besonders eignet sich dazu ein anisotroper Schmelzkleber.

Gemäß einem bevorzugten Ausführungsbeispiel erfolgt das Aufbringen des IC 5 indirekt unter Verwendung des bekannten TAB-Verfahrens (tape automatic bonding). Bei diesem Verfahren befindet sich der IC 5 bereits auf einer Kunststoffolie 6 die Leiterbahnen z.B. aus Kupfer aufweist die bereits mit den Anschlüssen des IC 5 verbunden sind. Bei der indirekten TAB-Technik werden nun diese Leiterbahnen auf der Folie 6 durch Kleben mit den Leiterbahnen 7 und 8 auf dem Glassubstrat 3 elektrisch leitend verbunden. Das Kleben erfolgt auch in diesem Fall zweckmäßig mit einem anisotropen Wärmeschmelzkleber.

Gemäß einem weiteren Auführungsbeispiel erfolgen die elektrisch leitenden Verbindungen des IC 5 mit den Ansteuerleitungen 7 mittels leitenden Klebers, die Verbindungen mit den Versorgungsleitungen 8 jedoch in einer Löttechnik.

## Patentansprüche

1. Schaltungsanordnung mit einem Glassubstrat auf dessen einer Oberfläche elektrische Leiterbahnen aufgebracht sind, die mit elektrischen Anschlüssen eines IC direkt oder indirekt elektrisch leitend verbunden sind, wobei ein Teil der Leiterbahnen Versorgungsleitungen für den IC und ein anderer Teil der Leiterbahnen als direkt auf die Glasoberfläche abgeschiedene ITO-Schichten ausgebildete Ansteuerleitungen für eine weitere elektronische Vorrichtung auf der gleichen Oberfläche des Glassubstrates sind, dadurch gekennzeichnet, daß die Versorgungsleiterbahnen (8) aus direkt oder indirekt auf die Glasoberfläche (4) aufgeklebten Metallfilmen bestehen, daß der IC (5) auf dem Glassubstrat (3) angeordnet ist und daß die elektrisch leitende Verbindung zwischen den Anschlüssen des IC (5) und den Ansteuerleiterbahnen (7) mittels eines anisotropen Klebers, und die Verbindungen zu den Versorgungsleitungen (8) mittels Löttechnik vorgenommen sind.

2. Schaltungsanordnung nach Anspruch 1, dadurch gekennzeichnet, daß die indirekte leitende Verbindung zwischen den Anschlüssen des IC (5) und den Leiterbahnen (7, 8) in der Weise vorgenommen ist, daß der IC (5) bereits auf einer mit Leiterbahnen versehenen Kunststoffolie (6) vormontiert ist und daß die Leiterbahnen der Kunststoffolie (6) mit den den Leiterbahnen (7, 8) auf der Oberfläche (4) des Glassubstrats elektrisch leitend verbunden sind.

3. Schaltungsanordnung nach Anspruch 1 oder 2, dadurch gekennzeichnet , daß das Glassubstrat (3) Teil einer der beiden das Flüssigkristallmaterial (1) einschließenden Deckplatten (1, 3) einer Flüssigkristall-Anzeigevorrichtung ist.

4. Schaltungsanordnung nach einem der Ansprüche 1 bis 3, dadurch gekennzeichnet, daß die Versorgungsleiterbahnen (8) aus auf die Glasoberfläche aufgeklebten Metallfolienbahnen bestehen.

5. Schaltungsanordnung nach einem der Ansprüche 1 bis 3, dadurch gekennzeichnet, daß die Versorgungsleiterbahnen (8) aus auf Kunststoffolie aufgebrachten Metallisierungsbahnen bestehen und daß die Kunststoffolie auf die Glasoberfläche aufgeklebt ist.

6. Schaltungsanordnung nach einem der Ansprüche 1 bis 5, dadurch gekennzeichnet, daß der anisotrope leitende Kleber ein Wärmeschmelzkleber ist.

## Claims

1. Circuit arrangement with a glass substrate, on one surface of which are applied electrical conductor tracks, which are directly or indirectly electrically conductively connected with electrical terminals of an integrated circuit, wherein a part of the conductor tracks are supply conductors for the integrated circuit and another part of the conductor tracks are drive control conductors, formed as ITO layers precipitated directly on the glass surface, for a further electronic device on the same surface of the glass substrate, characterised thereby that the supply conductor tracks (8) consist of metal films glued directly or indirectly onto the glass surface (4), that the integrated circuit (5) is arranged on the glass substrate (3) and that the electrically conductive connection between the terminals of the integrated circuit (5) and the drive control conductor tracks (7) is effected by means of an anistropic adhesive and the connections to the supply conductors (8) are effected out by means of soldering technique.

2. Circuit arrangement according to claim 1, characterised thereby that the indirect conductive connection between the terminals of the integrated circuit (5) and the conductor tracks (7, 8) is effected in the manner that the integrated circuit (5) is already premounted on a synthetic material foil (6) provided with conductor tracks and that the conductor tracks of the synthetic material film (6) are electrically conductively connected with the conductor tracks (7, 8) on the surface (4) of the glass substrate.

3. Circuit arrangement according to claim 1 or 2, characterised thereby that the glass substrate (3) is part of one of the two cover plates (1, 3), which include the liquid crystal material (1), of a liquid crystal display device.

4. Circuit arrangement according to one of the claims 1 to 3, characterised thereby that the supply conductor tracks (8) consist of metal foil tracks glued onto the glass surface.

5. Circuit arrangement according to one of claims 1 to 3, characterised thereby that the supply conductor tracks (8) consist of metal coating tracks applied to synthetic material foil and that the synthetic material foil is glued onto the glass surface.

6. Circuit arrangement according to one of claims 1 to 5, characterised thereby that the anistropic conductive adhesive is a heat fusion adhesive.

## Revendications

1. Montage comportant un substrat de verre sur l'une des faces duquel sont appliquées des pistes d'interconnexion électrique qui sont reliées électriquement, directement ou indirectement, aux bornes électriques d'un circuit intégré, une partie des pistes formant des lignes d'alimentation pour le circuit intégré et une autre partie des pistes formant des lignes de commande réalisées sous la forme de couches en oxyde d'indium-étain déposées directement sur la surface du verre et servant à un autre dispositif électronique se trouvant sur la même face du substrat de verre, caractérisée en ce que les pistes d'alimentation (8) sont formées de films métalliques collés directement et indirectement sur la surface de verre (4), que le circuit intégré (5) est disposé sur le substrat de verre (3) et que la liaison électriquement conductrice entre les bornes du circuit intégré (5) et les pistes de commande est réalisée au moyen d'une colle anisotrope, tandis que les liaisons avec les lignes d'alimentation (8) sont réalisées au moyen d'une technique de soudage.

2. Montage selon la revendication 1, caractérisé en ce que la liaison conductrice indirecte entre les bornes du circuit intégré (5) et les pistes d'interconnexion (7, 8) est réalisée du fait que le circuit intégré (5) est monté préalablement sur une feuille de matière plastique (6) pourvue de pistes d'interconnexion et que ces pistes de la feuille de matière plastique (6) sont reliées électriquement aux pistes d'interconnexion (7, 8) sur la surface (4) du substrat de verre.

3. Montage selon la revendication 1 ou 2, caractérisé en ce que le substrat de verre (3) fait partie d'une des deux plaques de recouvrement (1, 3) renfermant le matériau qui forme le cristal liquide (2) d'un dispositif d'affichage à cristaux liquides.

4. Montage selon une des revendications 1 à 3, caractérisé en ce que les pistes d'alimentation (8) sont constituées de rubans de feuille métallique collés sur la surface du verre.

5. Montage selon une des revendications 1 à 3, caractérisé en ce que les pistes d'alimentation (8) sont constituées de rubans de métallisation appliqués sur une feuille de matière plastique et que cette feuille de matière plastique est collée sur la surface de verre.

6. Montage selon une des revendications 1 à 5, caractérisé en ce que la colle conductrice anisotrope est une colle thermofusible.
